# FASCICULE DE BREVET EUROPEEN

(11) **EP 1 897 149 B1**
(45) Date de publication et mention de la délivrance du brevet: **20.11.2013**
(21) Numéro de dépôt: 06764850.1
(22) Date de dépôt: 07.06.2006
(51) Int. Cl.: H01L 31/18, C23C 2/00

(54) **RUBAN DE CARBONE DESTINE A ETRE RECOUVERT D'UNE COUCHE MINCE D'UN MATERIAU SEMI-CONDUCTEUR ET PROCEDE DE DEPOT D'UNE TELLE COUCHE**
EIN MIT EINER HALBLEITERMATERIALBESCHICHTUNG ABZUDECKENDE KOHLENSTOFFBAND UND VERFAHREN ZUR ABSCHEIDUNG EINER SOLCHEN SCHICHT
CARBON RIBBON TO BE COVERED WITH A THIN LAYER MADE OF A SEMICONDUCTOR MATERIAL AND METHOD FOR DEPOSITING A LAYER OF THIS TYPE

(30) Priorité: 17.06.2005 FR 0551655
(43) Date de publication de la demande: 12.03.2008
(73) Titulaire: Solarforce, 38300 Bourgoin Jallieu (FR)
(72) Inventeur: BELOUET, Christian, F-92330 Sceaux (FR)
(74) Mandataire: Lenne, Laurence
(86) Numéro de dépôt international: PCT/FR2006/050530
(87) Numéro de publication internationale: WO 2006/134292

(56) Documents cités:
- US-A- 3 429 734

## Description

La présente invention concerne un ruban de carbone destiné à être recouvert d'une couche mince d'un matériau semi-conducteur et un procédé pour déposer une telle couche sur un substrat constitué d'un ruban de carbone.

Les cellules photovoltaïques comportent des plaques minces d'un matériau semi-conducteur, le plus utilisé étant actuellement le silicium polycristallin. L'invention s'appliquant tout particulièrement au tirage de rubans de silicium destinés à la fabrication de cellules photovoltaïques, l'exposé qui suit fait donc référence au silicium, étant entendu que l'invention s'applique également à d'autres matériaux semi-conducteurs tels que le germanium et les composés semi-conducteurs de type III-V de la famille GaAs. à fusion congruente ou quasi-congruente. Les plaques de silicium sont obtenues de préférence à partir d'une couche de silicium, formant un film, déposée sur un substrat en carbone par tirage de ce substrat à travers un bain de silicium fondu. Le substrat a la forme d'un ruban.

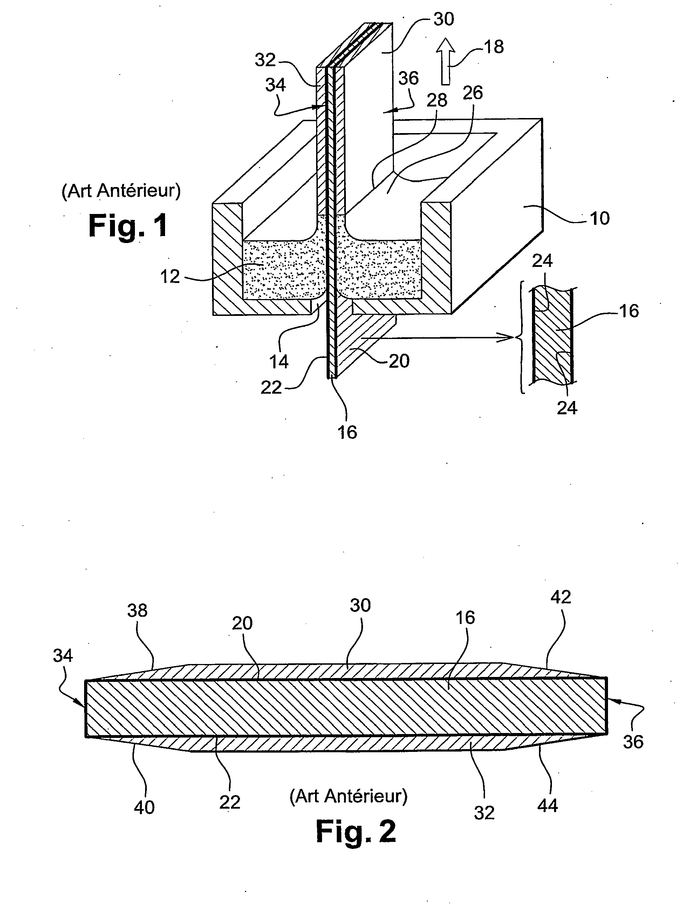

La figure 1 illustre de façon générale le procédé de l'art antérieur, désigné par procédé RST (pour Ruban sur Substrat Temporaire). Un creuset 10, équipé de moyens de chauffage (non représentés), contient un bain 12 de silicium fondu, sous forme liquide. Le fond du creuset est muni d'une fente 14. A l'aide de moyens de tirage non représentés, un ruban de carbone 16 de faible épaisseur (de l'ordre de 200 à 350 µm) est tiré sensiblement verticalement, de bas en haut dans le sens de la flèche 18, dans le bain 12 de silicium à vitesse sensiblement constante. Les deux faces 20 et 22 du ruban ont initialement été recouvertes d'une couche de carbone pyrolytique 24 de faible épaisseur (environ 1 à 5 µm). Le silicium fondu mouille les deux faces 20 et 22 du ruban et un ménisque 26 de silicium liquide se forme sur chaque face du ruban avec une ligne de raccordement solide-liquide 28 située à environ 6,8 mm de la surface du bain dans la partie centrale du ruban. Une couche mince de silicium 30-32 se forme alors sur chacune des deux faces 20 et 22 du ruban de carbone. La forme et les dimensions de la fente 14 sont adaptées, d'une part pour laisser pénétrer le ruban de carbone 16 dans le creuset et, d'autre part, pour éviter que du silicium fondu ne s'écoule à travers la fente. Bien qu'il soit avantageux d'obtenir simultanément deux films de silicium 30 et 32, un film par face du ruban, on peut concevoir de n'obtenir qu'un seul film en empêchant le dépôt de silicium sur l'une des deux faces.

Le procédé RST est par exemple décrit dans les brevets FR 2 386 359 et 2 561 139

Ce procédé de tirage est cependant confronté au problème de l'instabilité du ménisque de silicium liquide à proximité de chaque bord 34-36 du ruban de carbone 16. On a en effet constaté que la ligne de raccordement solide-liquide 28 tend à s'abaisser d'environ 6,8 mm à typiquement 2 à 4mm par rapport à la surface du bain de silicium sur les bords du ruban, sur une largeur d'environ 5mm à partir de chaque bord. Il en résulte que l'épaisseur de la couche de silicium 30 ou 32 déposée sur chaque face du ruban de carbone diminue vers les bords 34 et 36 jusqu'à atteindre une valeur pratiquement nulle.

La figure 2 illustre schématiquement l'amincissement progressif sur les bords des couches de semi-conducteur obtenues par le procédé de l'art antérieur représenté sur la figure 1. La section du ruban de carbone 16, représenté en coupe transversale et sans les couches 24 de carbone pyrolytique, a sensiblement une forme rectangulaire. Les deux couches de semi-conducteur 30 et 32 ont été déposées simultanément sur les deux faces respectivement 20 et 22 du ruban. Dans les zones 38-40 et 42-44 adjacentes aux deux bords respectivement 34 et 36 du ruban, l'épaisseur des couches diminue progressivement, sur une distance typiquement de l'ordre de 5 mm. Les films de semi-conducteur ainsi fabriqués sont donc particulièrement fragiles sur les bords. De plus, il apparaît une nucléation de grains de petites dimensions qui se propagent dans les parties latérales du film, ce qui a pour effet de diminuer les performances photovoltaïques du film de silicium.

Des solutions à ce problème ont été proposées dans les brevets FR 2 568 490 et 2 550 965. Ces solutions consistent à relever le niveau de la ligne solide-liquide sur les bords du ruban de carbone à l'aide de moyens extérieurs placés à proximité des bords du ruban. Ainsi le premier brevet cité fait appel à des plaquettes élevant localement par capillarité le niveau du bain de silicium fondu et le deuxième brevet cité propose de placer une goulotte en regard de chaque bord du ruban de silicium, également pour élever localement le niveau du bain de silicium fondu. Ces solutions compliquent la fabrication du bâti de tirage et l'opération de tirage elle-même.

La présente invention propose une solution à ce problème qui ne fait pas appel à des moyens extérieurs. Elle consiste à adapter la forme des bords du ruban de carbone utilisé comme support temporaire des couches de semi-conducteur, de façon à augmenter l'épaisseur des couches de semi-conducteur déposé sur les bords.

De façon plus précise, l'invention propose un procédé pour déposer une couche d'un matériau semi-conducteur sur au moins l'une des deux faces d'un ruban de carbone, ledit ruban comportant deux bords et étant tiré progressivement vers le haut, sensiblement verticalement, en traversant dans le sens de sa longueur la surface horizontale d'équilibre d'un bain dudit matériau semi-conducteur fondu, lequel se dépose par mouillage sur ladite face au fur et à mesure du tirage du ruban de carbone. Le procédé est caractérisé en ce qu'il consiste à modifier la forme des bords du ruban afin d'augmenter l'épaisseur de la couche de matériau semi-conducteur déposé sur les bords du ruban.

Selon une forme de mise en oeuvre, on donne à chacun des deux bords du ruban une forme de becquet, ladite forme pouvant être par exemple évasée, rectangulaire ou triangulaire.

Selon une forme de mise en oeuvre préférée, une couche de matériau semi-conducteur est déposée simultanément sur les deux faces du ruban et on donne à chacun des deux bords du ruban une forme de double becquet.

La modification de forme est par exemple obtenue par formage en repoussant en continu les bords du ruban l'un vers l'autre.

Lorsque le matériau semi-conducteur est du silicium, le ruban de carbone est avantageusement recouvert d'une couche de carbone pyrolytique sur laquelle est déposée la couche de silicium.

L'invention concerne également un ruban de carbone dont l'une au moins de ses deux faces est destinée à être recouverte d'une couche d'un matériau semi-conducteur en faisant traverser, sensiblement verticalement et de bas en haut, ledit ruban dans un bain dudit matériau semi-conducteur fondu. Selon l'invention, les deux bords d'au moins l'une des deux faces du ruban de carbone ont une forme saillant formant un becquet.

Selon un mode de réalisation, chacun des deux bords du ruban de carbone est évasé pour former une demie collerette ou une collerette selon que l'on considère une face uniquement du ruban ou les deux faces.

Selon un autre mode de réalisation, chaque bord du ruban forme un épaulement sensiblement perpendiculaire à la face du ruban destinée à recevoir la couche de matériau semi-conducteur, le becquet étant alors rectangulaire.

Selon un autre mode de réalisation, chaque bord du ruban forme un épaulement oblique par rapport à la face du ruban destinée à recevoir la couche de matériau semi-conducteur, le becquet étant alors triangulaire.

Chacun des deux bords du ruban comportent avantageusement une partie externe sensiblement perpendiculaire à la face du ruban destinée à recevoir la couche de matériau semi-conducteur, cette partie externe pouvant comporter une partie rentrée en direction du ruban ou être en forme de demie goutte de suif ou en forme de goutte de suif.

Selon un mode de réalisation, le matériau semi-conducteur est déposé sur les deux faces du ruban, chaque bord du ruban de carbone formant alors un double becquet.

Le matériau semi-conducteur est choisi parmi le silicium, le germanium et les composés semi-conducteurs de type III-V de la famille GaAs à fusion congruente ou quasi-congruente.

D'autres caractéristiques et avantages de l'invention ressortiront de la description suivante, donnée uniquement à titre d'exemple et faite en référence aux dessins annexés sur lesquels :
- la figure 1 représente schématiquement le procédé selon l'art antérieur permettant d'obtenir un ou deux films de matériaux semi-conducteurs par tirage d'un ruban de carbone dans un bain de semi-conducteur fondu;
- la figure 2 illustre l'amincissement des couches de semi-conducteur obtenues par le procédé classique de l'art antérieur, et
- les figures 3a, 3b, 3c et 3d représentent schématiquement et en coupe des formes de réalisation d'un bord du ruban de carbone conformes à l'invention.

Selon l'invention, la forme des bords du ruban de carbone est modifiée de façon à modifier la forme de la surface de mouillage du matériau semi-conducteur fondu sur les deux bords du ruban, dans le but d'augmenter l'épaisseur de la couche de matériau semi-conducteur déposé sur les bords du ruban.

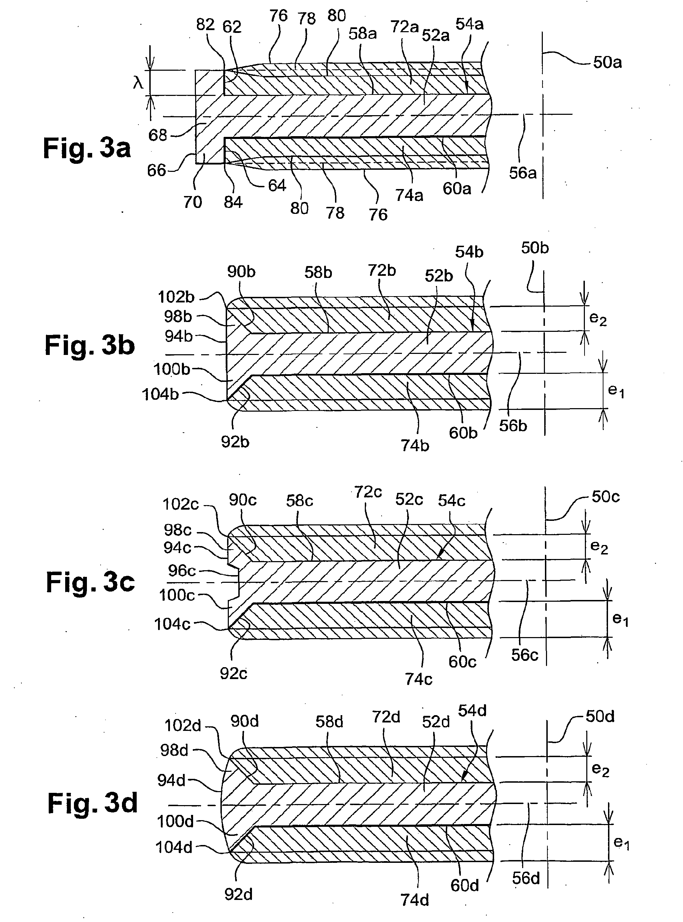

Les figures 3a, 3b, 3c et 3d représentent schématiquement et en coupe transversale plusieurs formes de réalisation du ruban de carbone conforme à la présente invention. Pour simplifier l'écriture et la lecture de ce qui suit, lorsqu'une référence par exemple R concerne les modes de réalisation des figures 3a, 3b, 3c et 3d, on écrira Ra,b,c,d au lieu de Ra, Rb, Rc, Rd. Si la référence R ne concerne par exemple que les modes de réalisation des figures 3b, 3c et 3d, on écrira 3b,c,d.

Sur ces figures, le ruban est montré revêtu de deux couches de semi-conducteur, chacune d'elles formant un film de semi-conducteur après élimination du ruban de carbone. Le plan médian 50a,b,c,d passant par le milieu du ruban et perpendiculaire aux deux faces du ruban constitue un plan de symétrie. Ainsi, sur ces figures 3, seule l'extrémité gauche du ruban est représentée, l'extrémité droite étant identique à l'extrémité gauche et symétrique par rapport à ce plan médian 50a,b,c,d.

Sur les figures 3a à 3d, les rubans de carbone sont identiques, à l'exception de la forme des bords des rubans. Mises à part ces bords, les sections transversales 52a,b,c,d des rubans de carbone 54a,b,c,d sont généralement de forme rectangulaire et possède un axe de symétrie longitudinal 56a, 56b, 56c ou 56d parallèle aux deux faces du ruban respectivement 58a-60a, 58b-60b, 58c-60c et 58d-60d. Les deux bords de chacune des deux faces des rubans se terminent de façon saillante pour former un becquet. La forme saillante permet d'augmenter l'épaisseur de la couche de matériau semi-conducteur déposé sur les bords du ruban.

Ainsi sur la figure 3a, les deux extrémités ou bords de chacune des faces 58a et 60a se terminent chacune par une paroi respectivement 62 ou 64, formant un épaulement, sensiblement perpendiculaire aux faces 58a et 60a. Si la longueur de l'épaulement est égale à ?, l'épaisseur des bords du ruban de carbone est plus grande de 2? par rapport à l'épaisseur au centre du ruban. Le côté latéral du ruban est formé par une paroi 66 sensiblement perpendiculaire à l'axe de symétrie longitudinal 56a. Le bord du ruban situé au-dessus de l'axe de symétrie longitudinal 56a forme avec l'extrémité de la face 58a et la paroi 62 un becquet rectangulaire 68 de forme saillante par rapport à la face 58a. De même, le bord du ruban situé en dessous de l'axe de symétrie longitudinal 56a forme avec l'extrémité de la face 60a et la paroi 64 un becquet rectangulaire 70 de forme saillante par rapport à la face 60a. L'ensemble des becquets 68 et 70 constitue un double becquet.

Deux couches de semi-conducteur 72 et 74 peuvent être déposées sur les faces du ruban de carbone, selon le procédé décrit précédemment en regard de la figure 1, après avoir déposée au préalable une couche de graphite pyrolytique sur les deux faces du ruban de carbone. L'épaisseur des couches de semi-conducteur varie en fonction de la vitesse de tirage du ruban. La hauteur ? du becquet est choisie avantageusement égale ou inférieure à l'épaisseur de la couche de semi-conducteur. Sur la figure 3a, trois épaisseurs de couche ont été représentées afin d'illustrer le profil des faces extérieures 76, 78 et 80 des couches au niveau des becquets 68 et 70. On remarque que les couches, quelle que soit leurs épaisseurs, s'accrochent à l'extrémité 82 ou 84 du becquet 68 ou 70. Il en résulte que l'épaisseur des bords des couches de semi-conducteur ne diminue plus pour tendre vers une épaisseur voisine de zéro comme dans l'art antérieur. De plus, le semi-conducteur ne se dépose pratiquement pas sur le côté latéral du ruban de carbone constitué par la paroi 66. Cette absence de semi-conducteur sur la paroi 66 facilite une opération ultérieure du procédé RST consistant à brûler le ruban de carbone dans un four afin de séparer les deux couches de semi-conducteur 72 et 74.

Sur les figures 3b, 3c et 3d, les bords des rubans ont une forme saillant, en forme d'un double becquet triangulaire. Les bords des faces 58b,c,d et 60b,c,d des rubans sont constitués chacun de deux parois 90b,c,d et 92b,c,d inclinées vers l'extérieur par rapport aux faces du ruban et d'une paroi 94b,c,d sensiblement perpendiculaire à l'axe de symétrie longitudinal 56b,c,d. Les parois 94b,c,d forment les côtés latéraux des rubans. La forme de ces côtés est différente selon les figures : sur la figure 3b, la paroi 94b a une forme plane; sur la figure 3c, la paroi 94c comporte un renfoncement 96c; sur la figure 3d, la paroi 94d a une forme en goutte de suif (ou en demie goutte de suif si l'on ne considère qu'une face 58d ou 60d avec la paroi respectivement 90d ou 92d).

Chacune des parois 90b,c,d forme avec les côtés 94b,c,d un becquet triangulaire 98b,c,d. Egalement, chacune des parois 92b,c,d forme avec les côtés 94b,c,d un becquet triangulaire 100b,c,d. Les becquets 98b et 100b forment ensemble un double becquet triangulaire. Il en est de même des becquets 98c et 100c d'une part et 98d et 100d d'autre part.

Les parois 90b,c,d et 92b,c,d peuvent ne pas être planes et prendre une forme évasée tournée vers l'extérieur du ruban. Dans ce cas, la section transversale des bords des rubans prend la forme d'une collerette.

Des couches de semi-conducteur 72b,c,d et 74b,c,d ont été déposées sur les faces des rubans respectivement 58b,c,d et 60b,c,d, après avoir revêtu les faces des rubans de carbone pyrolytique. Deux épaisseurs e₁ et e₂ de couches de semi-conducteur sont représentées sur chacune des figures 3b,c,d afin d'illustrer l'accrochage des couches aux extrémités 102b,c,d et 104b,c,d des becquets. On remarque que l'épaisseur des couches est pratiquement constante, y compris sur les bords du ruban.

Comme pour le mode de réalisation montré sur la figure 3a, le dépôt de semi-conducteur sur les côtés latéraux 94b,c,d peut être minimisé ou éliminé, ce qui facilite les opérations ultérieures d'ouverture du chant du ruban de carbone pour l'élimination du ruban de carbone par brûlage.

Le ruban de carbone utilisé dans le procédé RST est relativement mou et plastique. Il est souple, de faible densité et réalisé par laminage à froid de graphite naturel expansé. La masse surfacique de ce ruban est typiquement de 150 à 200 g/m² et son épaisseur de l'ordre de 250 µm. Dû à ce caractère mou et plastique du ruban de carbone, la modification de forme de ses bords (de forme parallélépipédique rectangle) ne présente pas de difficultés. Elle peut être réalisée par tout moyen approprié, notamment par une méthode de formage par repoussage en continu à l'aide de moyens mécaniques qui exercent une pression sur les deux bords du rubans, pression dirigée vers l'intérieur du ruban et selon l'axe de symétrie 56a, b, c,d. Il est également possible de modifier la forme des bords par écrasement contrôlé selon la forme à donner.

Après modification de la forme des bords du ruban, les faces de ce dernier (y compris les bords) sont avantageusement recouvertes d'une couche de carbone pyrolytique d'épaisseur comprise entre 1 à 5 pm. Après cette opération, le ruban de carbone est enroulé simultanément avec un film de papier ou de plastique récupérable, dont l'épaisseur est choisie de façon à ne pas écraser le double becquet au cours de lenroulement. Avec un becquet de hauteur ? (voir figure 3a), l'épaisseur du film de papier ou de plastique doit être au moins égale à ?. Lors de l'opération de tirage du ruban de carbone à travers le bain de semi-conducteur, le film de papier ou de plastique est séparé du ruban de carbone et récupéré pour une nouvelle utilisation.

On peut noter que le double becquet à chaque bord du ruban de carbone ne complique pas le mode de défilement du ruban à travers la fente 14 du creuset 10 (figure 1), celle-ci comportant en général à chacune de ses deux extrémités deux trous de diamètre supérieur à la largeur de la fente, tel que décrit dans le brevet FR 2 561 139.

L'invention apporte une solution techniquement simple et bon marché au problème de la diminution, sur les bords, de l'épaisseur des couches de semi-conducteur obtenues par tirage d'un ruban de carbone. On améliore ainsi le rendement d'utilisation de la surface du ruban et de la surface de semi-conducteur. La forme saillante, notamment en becquet, donnée au profil des bords du ruban réduit la fragilité des rubans et améliore ainsi le rendement de fabrication des films de semi-conducteur.

D'autres modes de réalisation que ceux décrits et représentés peuvent être conçus par l'homme du métier sans sortir du cadre de la présente invention, les modes de réalisation représentés sur les figures 3a,b,c,d n'étant que des exemples de réalisation parmi d'autres possibles.

## Revendications

1. Procédé pour déposer une couche (72, 74) d'un matériau semi-conducteur sur au moins l'une des deux faces (58, 60) d'un ruban de carbone (54), ledit ruban comportant deux bords (34, 36), selon le procédé le ruban est tiré progressivement vers le haut (18), sensiblement verticalement, en traversant dans le sens de sa longueur la surface horizontale d'équilibre d'un bain (12) du matériau semi-conducteur fondu, lequel se dépose par mouillage sur ladite face au fur et à mesure du tirage du ruban de carbone, le procédé étant **caractérisé en ce qu'**il consiste à modifier la forme (62-64-66, 90-92-94) des bords du ruban de façon à augmenter l'épaisseur de la couche de matériau semi-conducteur déposé sur les bords du ruban.

2. Procédé selon la revendication 1 **caractérisé en ce que** l'on donne à chacun des bords du ruban une forme de becquet (68, 70, 98, 100).

3. Procédé selon la revendication 2 **caractérisé en ce que** ledit becquet a une forme évasée; sensiblement rectangulaire (68, 70) ou sensiblement triangulaire (98, 100).

4. Procédé selon l'une des revendications précédentes **caractérisé en ce que**, une couche (72, 74) de matériau semi-conducteur étant déposée simultanément sur les deux faces (58, 60) du ruban, on donne à chacun des bords du ruban une forme de double becquet (68-70, 98-100).

5. Procédé selon l'une des revendications précédentes **caractérisé en ce que** la modification de forme est obtenue par formage en repoussant en continu les deux bords du ruban l'un vers l'autre.

6. Procédé selon l'une des revendications 1 à 3 **caractérisé en ce que** la modification de forme est obtenue par écrasement des bords.

7. Procédé selon l'une des revendications précédentes **caractérisé en ce que** ledit matériau semi-conducteur est choisi parmi le silicium, le germanium et les composés semi-conducteurs de type III-V de la famille GaAs à fusion congruente ou quasi-congruente.

8. Procédé selon l'une des revendications précédentes **caractérisé en ce que**, ledit matériau semi-conducteur étant du silicium, le ruban de carbone est recouvert d'une couche de carbone pyrolytique (24) sur laquelle est déposée la couche de silicium.

9. Ruban de carbone (54) ayant deux bords et dont l'une au moins de ses deux faces (58, 60) est destinée à être recouverte d'une couche (72, 74) d'un matériau semi-conducteur en faisant traverser, sensiblement verticalement et de bas en haut, ledit ruban dans un bain (12) du matériau semi-conducteur fondu, le ruban de carbone étant **caractérisé en ce que** chacun de ses deux bords d'au moins l'une de ses deux faces est saillant pour former un becquet (68, 70, 98, 100).

10. Ruban selon la revendication 9 **caractérisé en ce que** chacun desdits bords est évasé afin de former une demie collerette.

11. Ruban (54a) selon la revendication 9 **caractérisé en ce que** chacun desdits bords forme un épaulement sensiblement perpendiculaire (62, 64) à ladite face (58a, 60a) du ruban destinée à recevoir la couche (72a, 74a) de matériau semi-conducteur, ledit becquet (68, 70) étant alors sensiblement rectangulaire.

12. Ruban (54b,c,d) selon la revendication 9 **caractérisé en ce que** chacun desdits bords forme un épaulement oblique (90b,c,d, 92b,c,d) par rapport à ladite face (58b,c,d, 60b,c,d) du ruban destinée à recevoir la couche (72b,c,d, 74b,c,d) de matériau semi-conducteur, ledit becquet (98b,c,d, 100b,c,d) étant alors sensiblement triangulaire.

13. Ruban selon l'une des revendications précédentes **caractérisé en ce que** chacun desdits bords comporte une partie externe (66, 94) sensiblement perpendiculaire à ladite face du ruban destinée à recevoir la couche de matériau semi-conducteur.

14. Ruban (54c) selon la revendication 13 **caractérisé en ce que** ladite partie externe comporte une partie rentrée (96c) en direction du ruban.

15. Ruban (54d) selon la revendication 13 **caractérisé en ce que** ladite partie externe est en forme de demie goutte de suif (94d).

16. Ruban selon l'une des revendications 9 à 15 **caractérisé en ce que**, ledit matériau semi-conducteur étant déposé sur les deux faces du ruban, chacun des deux bords du ruban de carbone forme un double becquet (68-70, 98b,c,d-100b,c,d).

17. Ruban selon les revendications 10 et 16 **caractérisé en ce que** chacun des deux bords forme une collerette.

18. Ruban (54d) selon les revendications 15 et 16 **caractérisé en ce que** ladite partie externe est en forme de goutte de suif (94d).

19. Ruban selon l'une des revendications précédentes **caractérisé en ce que** ledit matériau semi-conducteur est choisi parmi le silicium, le germanium et les composés semi-conducteurs de type III-V de la famille GaAs à fusion congruente ou quasi-congruente.

## Patentansprüche

1. Verfahren zum Aufbringen einer Schicht (72, 74) eines Halbleitermaterials auf mindestens eine der zwei Seiten (58, 60) eines Kohlenstoffbands (54), wobei das Band zwei Ränder (34, 36) aufweist, wobei das Band gemäß dem Verfahren schrittweise etwa senkrecht nach oben (18) gezogen wird, wobei es in seiner Längsrichtung die waagerechte Ausgleichsfläche eines Bads (12) des geschmolzenen Halbleitermaterials durchquert, das sich durch Benetzen auf der Fläche nach und nach gemäß dem Zug des Kohlenstoffbands auf der Fläche ablagert, wobei das Verfahren **dadurch gekennzeichnet ist, dass** es darin besteht, die Form (62-64-66, 90-92-94) der Ränder des Bands derart zu ändern, dass die Dicke der auf den Rändern des Bands aufgebrachten Halbleitermaterialschicht erhöht wird.

2. Verfahren nach Anspruch 1, **dadurch gekennzeichnet, dass** jedem der Ränder des Bands eine Spoilerform (68, 70, 98,100) gegeben wird.

3. Verfahren nach Anspruch 2, **dadurch gekennzeichnet, dass** der Spoiler eine erweiterte, etwa rechteckig (68,70) oder etwa dreieckige (98, 100) Form hat.

4. Verfahren nach einem der vorangehenden Ansprüche, **dadurch gekennzeichnet, dass**, wobei eine Halbleitermaterialschicht (72, 74) gleichzeitig auf den zwei Seiten (58, 60) des Bands aufgebracht wird, jedem der Ränder des Bands eine Doppelspoilerform (68-70, 98-100) gegeben wird.

5. Verfahren nach einem der vorangehenden Ansprüche, **dadurch gekennzeichnet, dass** die Formänderung durch Formen durch kontinuierliches Zurückdrücken der zwei Ränder des Bands zueinander erhalten wird.

6. Verfahren nach einem der Ansprüche 1 bis 3, **dadurch gekennzeichnet, dass** die Formänderung durch Stauchen der Ränder erhalten wird.

7. Verfahren nach einem der vorangehenden Ansprüche, **dadurch gekennzeichnet, dass** das Halbleitermaterial aus dem Silizium, dem Germanium und den Halbleiterverbindungen vom Typ III-V aus der Famille GaAs mit kongruenter oder quasi kongruenter Fusion ausgewählt ist.

8. Verfahren nach einem der vorangehenden Ansprüche, **dadurch gekennzeichnet, dass**, wobei das Halbleitermaterial Silizium ist, das Kohlenstoffband mit einer Schicht prolytischen Kohlenstoffs (24) bedeckt ist, auf der die Siliziumschicht aufgebracht ist.

9. Kohlenstoffband (54) mit zwei Rändern und von dem mindestens eine seiner zwei Seiten (58, 60) dazu bestimmt ist, mit einer Schicht (72, 74) eines Halbleitermaterials bedeckt zu sein, indem das Band etwa senkrecht von unten nach oben ein Bad (12) des geschmolzenen Halbleitermaterials durchquert, wobei das Kohlenstoffband **dadurch gekennzeichnet ist, dass** jeder seiner zwei Ränder mindestens einer seiner zwei Seiten hervorsteht, um einen Spoiler (68, 70, 98, 100) zu bilden.

10. Band nach Anspruch 9, **dadurch gekennzeichnet, dass** jeder der Ränder erweitert ist, um einen halben Kragen zu bilden.

11. Band (54a) nach Anspruch 9, **dadurch gekennzeichnet, dass** jeder der Ränder einen Absatz bildet, der etwa lotrecht (62, 64) zu der Seite (58a, 60a) des Bands ist, die dazu bestimmt ist, die Halbleitermaterialschicht (72a, 74a) aufzunehmen, wobei der Spoiler (68, 70) dann etwa rechtwinklig ist.

12. Band (54b, c, d) nach Anspruch 9, **dadurch gekennzeichnet, dass** jeder der Ränder einen im Verhältnis zu der Seite (58b, c, d, 60b, c, d) des Bands, die dazu bestimmt ist, die Halbleitermaterialschicht (72b, c, d, 74b, c, d) aufzunehmen, schrägen Absatz (90b, c, d, 92b, c, d) bildet, wobei der Spoiler (98b, c, d, 100b, c, d) dann etwa dreieckig ist.

13. Band nach einem der vorangehenden Ansprüche, **dadurch gekennzeichnet, dass** jeder der Ränder einen externen Teil (66, 94) aufweist, der etwa lotrecht zu der Seite des Bands ist, die dazu bestimmt ist, die Halbleitermaterialschicht aufzunehmen.

14. Band (54c) nach Anspruch 13 **dadurch gekennzeichnet, dass** der externe Teil einen in Richtung des Bands eingezogenen Teil (96c) aufweist.

15. Band (54d) nach Anspruch 13, **dadurch gekennzeichnet, dass** der externe Teil die Form eines halben Linsenkopfs (94d) hat.

16. Band nach einem der Ansprüche 9 bis 15, **dadurch gekennzeichnet, dass**, wobei das Halbleitermaterial auf den zwei Seiten des Bands aufgebracht ist, jeder der zwei Ränder des Kohlenstoffbands einen Doppelspoiler (68-70, 98b, c, d-100b, c, d) bildet.

17. Band nach den Ansprüchen 10 und 16, **dadurch gekennzeichnet, dass** jeder der zwei Ränder einen Kragen bildet.

18. Band (54d) nach den Ansprüchen 15 und 16, **dadurch gekennzeichnet, dass** der externe Teil in Linsenkopfform (94d) ist.

19. Band nach einem der vorangehenden Ansprüche, **dadurch gekennzeichnet, dass** das Halbleitermaterial aus dem Silizium, dem Germanium und den Halbleiterverbindungen vom Typ III-V aus der Famille GaAs mit kongruenter oder quasi kongruenter Fusion ausgewählt ist.

## Claims

1. A method for depositing a layer (72, 74) of a semiconductor material on at least one of the two faces (58, 60) of a carbon tape (54), said tape including two edges (34, 36), according to the method, the tape is gradually pulled upward (18), substantially vertically, while crossing, in the direction of its length, the horizontal equilibrium surface of a bath (12) of the molten semiconductor material, which is deposited on said surface by wetting as the carbon tape is pulled, the method being **characterized in that** it consists of modifying the shape (62-64-66, 90-92-94) of the edges of the tape so as to increase the thickness of the layer of semiconductor material deposited on the edges of the tape.

2. The method according to claim 1, **characterized in that** each of the edges of the tape is given the shape of a spoiler (68, 70, 98, 100).

3. The method according to claim 2, **characterized in that** said spoiler has a flared, substantially rectangular (68, 70) or substantially triangular (98, 100) shape.

4. The method according to one of the preceding claims, **characterized in that**, a layer (72, 74) of semiconductor material being deposited simultaneously on both faces (58, 60) of the tape, each of the edges of the tape is given a double-spoiler shape (68-70, 98-100).

5. The method according to one of the preceding claims, **characterized in that** the shape modification is obtained by shaping by continuously pushing the two edges of the tape toward each other.

6. The method according to one of claims 1 to 3, **characterized in that** the shape modification is obtained by crushing of the edges.

7. The method according to one of the preceding claims, **characterized in that** said semiconductor material is chosen from among silicon, germanium and semiconductor compounds of type III-V from the GaAs family with congruent or quasi-congruent melting.

8. The method according to one of the preceding claims, **characterized in that**, said semiconductor material being silicon, the carbon tape is covered with a layer of pyrolytic carbon (24) on which the layer of silicon is deposited.

9. A carbon tape (54) having two edges and whereof at least one of its two faces (58, 60) is intended to be covered with a layer (72, 74) of a semiconductor material by causing said tape to cross, substantially vertically and from bottom to top, through a bath (12) of the molten semiconductor material, the carbon tape being **characterized in that** each of its two edges of at least one of its two faces protrudes to form a spoiler (68, 70, 98, 100).

10. The tape according to claim 9, **characterized in that** each of said edges is flared so as to form a half-collar.

11. The tape (54a) according to claim 9, **characterized in that** each of said edges forms a shoulder (62, 64) substantially perpendicular to said face (58a, 60a) of the tape intended to receive the layer (72a, 74a) of semiconductor material, said spoiler (68, 70) being substantially rectangular.

12. The tape (54b,c,d) according to claim 9, **characterized in that** each of said edges forms an oblique shoulder (90b,c,d, 92b,c,d) relative to said face (58b,c,d, 60b,c,d) of the tape intended to receive the layer (72b,c,d, 74b,c,d) of semiconductor material, said spoiler (98b,c,d, 100b,c,d) then being substantially triangular.

13. The tape according to one of the preceding claims, **characterized in that** each of said edges includes an outer portion (66, 94) substantially perpendicular to said face of the tape intended to receive the layer of semiconductor material.

14. The tape (54c) according to claim 13, **characterized in that** said outer portion includes a portion (96c) indented toward the tape.

15. The tape (54d) according to claim 13, **characterized in that** said outer portion is in the shape of a half-double cabochon (94d).

16. The tape according to one of claims 9 to 15, **characterized in that**, said semiconductor material being deposited on both faces of the tape, each of the two edges of the carbon tape forms a double spoiler (68-70, 98b,c,d-100b,c,d).

17. The tape according to claims 10 and 16, **characterized in that** each of the two edges forms a collar.

18. The tape (54d) according to claims 15 and 16, **characterized in that** said outer portion is in the shape of a double cabochon (94d).

19. The tape according to one of the preceding claims, **characterized in that** said semiconductor material is chosen from among silicon, germanium and semiconductor compounds of type III-V of the GaAs family with congruent or quasi-congruent melting.
